# EUROPÄISCHE PATENTSCHRIFT

(11) **EP 2 069 804 B1**
(45) Veröffentlichungstag und Bekanntmachung des Hinweises auf die Patenterteilung: **12.08.2015**
(21) Anmeldenummer: 07819740.7
(22) Anmeldetag: 10.11.2007
(51) Int. Cl.: G01R 19/165

(54) **ELEKTRONISCHE ÜBERWACHUNG DES BORDNETZES EINES KRAFTFAHRZEUGS AUF SPANNUNGSSPITZEN ODER SPANNUNGSEINBRÜCHE**
ELECTRONIC MONITORING OF THE WIRING LOOM OF A MOTOR VEHICLE FOR VOLTAGE PEAKS OR VOLTAGE DIPS
SURVEILLANCE ÉLECTRONIQUE DE POINTES DE TENSION OU DE CHUTES DE TENSION DU TABLEAU DE BORD D'UN VÉHICULE AUTOMOBILE

(30) Priorität: 16.11.2006 DE 102006054016
(43) Veröffentlichungstag der Anmeldung: 17.06.2009
(73) Patentinhaber: Bayerische Motoren Werke Aktiengesellschaft, 80809 München (DE)
(72) Erfinder: BÄR, Mathias, 08107 Kirchberg (DE); KELLNER, Robert, 80999 München (DE); DREES, Rainer, 81541 München (DE)
(74) Vertreter: Grüter, Klaus Peter
(86) Internationale Anmeldenummer: PCT/EP2007/009748
(87) Internationale Veröffentlichungsnummer: WO 2008/058686

(56) Entgegenhaltungen:
- EP-A- 0 390 680
- WO-A-2006/061033
- US-A- 3 813 667

## Beschreibung

Die Erfindung betrifft ein Verfahren zur elektronischen Überwachung des Bordnetzes oder von Teilen des Bordnetzes eines Kraftfahrzeugs auf Spannungsspitzen oder Spannungseinbrüche.

Spannungsspitzen oder Spannungseinbrüche im Bordnetz eines Kraftfahrzeugs mit zahlreichen Steuergeräten können zu Fehlern in der Funktionsweise des Bordnetzes führen, die fälschlicherweise einem oder mehreren Steuergeräten zugeschrieben werden. Spannungsspitzen oder Spannungseinbrüche können nur in der Werkstatt und damit nicht unter realen Betriebsbedingungen des Kraftfahrzeugs durch Oszilloskope oder dergleichen erkannt und ihr Ausmaß ermittelt werden. Dies gilt insbesondere dann, wenn es sich um kurzzeitige und/oder unregelmäßig auftretende Spitzen oder Einbrüche handelt.

Aus der EP 0 390 680 A ist ein gattungsgemäßes Verfahren bekannt

Die WO 2006/061033 A beschäftigt sich mit dem Problem ein einfaches Verfahren zur strukturierten Speicherung von Fehlereinträgen der Teilnehmer eines Datenbusses in einem Kraftfahrzeug zu schaffen, durch welches Fehlereinträge im Fehlerfall zuverlässig auffindbar sind. Beim Auftreten eines Fehlers soll eine von dem Fehler möglicherweise beeinflusste Funktion und die Mitglieder einer zugehörigen funktionsspezifischen Gruppe diagnoserelevanter Teilnehmer bestimmt werden. Bei einem ersten Mitglied der funktionsspezifischen Gruppe wird ein Fehlereintrag erstellt und bei einem zweiten Mitglied der funktionsspezifischen Gruppe wird ein auf das erste Mitglied verweisender Diagnosezeiger abgelegt.

Aus der US 3 813 667 A ist eine Vorrichtung u.a. zur Überwachung von Über- und Unterspannungen über bzw. unter einem Schwellenwert einer Spannungsquelle bekannt. Ein Schaltkreis zählt jeweils die betreffenden Störungen bei der Bereitstellung der Spannung. Ein Alarm-Schaltkreis veranlasst die Ausgabe eines visuellen oder akustischen Alarms, wenn bei der Überwachung mindestens eine betreffende Störung ermittelt wird.

Aufgabe der Erfindung ist es insbesondere, ein Verfahren und eine Vorrichtung vorzuschlagen, mit der Spannungsspitzen oder Spannungseinbrüche im Bordnetz eines Kraftfahrzeugs kostengünstig erkannt werden können.

Diese Aufgabe wird durch die betreffenden unabhängigen Patentansprüche jeweils gelöst. Vorteilhafte Ausgestaltungen der Erfindung sind Gegenstand der abhängigen Patentansprüche.

Die Erfindung betrifft ein Verfahren zur elektronischen Überwachung des Bordnetzes oder von Teilen des Bordnetzes eines Kraftfahrzeugs auf Spannungsspitzen oder Spannungseinbrüche. Der Wert der elektrischen Spannung wird fortlaufend erfasst und eine Komparator-Schaltung vergleicht fortlaufend einen ersten früheren Spannungswert mit einem zweiten nachfolgend ermittelten Spannungswert. Die Komparator-Schaltung hält den bislang erfassten höchsten Spannungswert für einen vorbestimmten Zeitraum bereit.

Erfindungsgemäß wird die elektrische Spannung der Primär- und/oder Sekundärseite des Zündspannungskreises des Kraftfahrzeugs, ggf. nach einer Reduzierung der Messspannung durch einen Spannungsteiler, fortlaufend überwacht. Hierdurch kann kostengünstig ermittelt werden, ob der Zündspannungskreis die erforderliche Zündspannung für die betreffenden Betriebszustände einer Verbrennungsmaschine des Kraftfahrzeugs zur Verfügung stellt.

Eine solche Komparator-Schaltung kann kostengünstig realisiert werden. Preisgünstig erhältliche Komparatoren sind zudem in der Lage sehr kurzzeitige "Peaks" mit einer Gesamtzeitdauer im Bereich von beispielsweise 10 µs zu erkennen und deren Maximal- bzw. Spitzenspannung zu erfassen. Eine kostenaufwändige Erfassungs-Vorrichtung mit einer entsprechend hohen Abtastrate zur Erfassung solch kurzer Pulse oder Peaks kann mit dem erfindungsgemäßen Verfahren umgangen werden. Bei einer Ausführungsform der Erfindung ist vorgesehen, dass der bislang erfasste höchste Spannungswert beim Auftreten eines Fehlers im Bordnetz oder in einem im Bordnetz befindlichen Steuergerät zusammen mit einer Beschreibung des Fehlers in einem Fehlerspeicher gespeichert wird. Hierdurch wird die Fehlersuche deutlich erleichtert bzw. vermieden, dass ein Fehler z.B. irrtümlicherweise einem Steuergerät angelastet wird.

Bei einer Ausgestaltung der Erfindung ist vorgesehen, dass der bislang erfasste höchste Spannungswert von der Komparator-Schaltung mit einem vorbestimmten Schwellenwert verglichen wird, und der bislang erfasste höchste Spannungswert bei Überschreiten des vorbestimmten Schwellenwerts von der Komparator-Schaltung gespeichert wird. Hierdurch wird das Auftreten signifikanter Spannungssprünge dokumentiert.

Bei einer anderen Ausgestaltung der Erfindung wird der bislang erfasste höchste Spannungswert von der Komparator-Schaltung mit einem Zeitstempel versehen und gespeichert. Indem auch der Zeitpunkt des Auftretens des Spannungssprungs dokumentiert wird, wird die Zuordnung von Spannungssprüngen zu Fehlern, die im Bordnetz oder in Steuergeräten des Bordnetzes auftreten, erleichtert.

Das erfindungsgemäße Verfahren ermöglicht zudem die Bereitstellung einer vorteilhaften Vorrichtung zur elektronischen Überwachung des Bordnetzes oder von Teilen des Bordnetzes eines Kraftfahrzeugs auf Spannungsspitzen oder Spannungseinbrüche sowie ein entsprechendes Bordnetz.

Wenn vorstehend vom höchsten Spannungswert oder von einer Spannungsspitze die Rede ist, soll dies sinngemäß im Rahmen weiterer nicht explizit beschriebener Ausführungsbeispiele auch für den niedrigsten Spannungswert bzw. für Spannungseinbrüche gelten. In diesen Fällen wird dann beispielsweise mit einem unteren Schwellenwert verglichen.

## Patentansprüche

1. Verfahren zur elektronischen Überwachung des Bordnetzes oder von Teilen des Bordnetzes eines Kraftfahrzeugs auf Spannungsspitzen oder Spannungseinbrüche, bei dem
- der Wert der elektrischen Spannung fortlaufend erfasst wird und eine Komparator-Schaltung fortlaufend einen ersten früheren Spannungswert mit einem zweiten nachfolgend ermittelten Spannungswert vergleicht, und
- die Komparator-Schaltung den bislang erfassten höchsten Spannungswert für einen vorbestimmten Zeitraum bereithält, **dadurch gekennzeichnet, dass**
- die elektrische Spannung der Primär- und/oder Sekundärseite des Zündspannungskreises des Kraftfahrzeugs, ggf. nach einer Reduzierung der Messspannung durch einen Spannungsteiler, fortlaufend überwacht wird.

2. Verfahren nach Anspruch 1, **dadurch gekennzeichnet, dass** der bislang erfasste höchste Spannungswert beim Auftreten eines Fehlers im Bordnetz oder in einem im Bordnetz befindlichen Steuergerät zusammen mit einer Beschreibung des Fehlers in einem Fehlerspeicher gespeichert wird.

3. Verfahren nach einem der vorstehenden Ansprüche, **dadurch gekennzeichnet, dass** der bislang erfasste höchste Spannungswert von der Komparator-Schaltung mit einem vorbestimmten Schwellenwert verglichen wird, und der bislang erfasste höchste Spannungswert bei überschreiten des vorbestimmten Schwellenwerts von der Komparator-Schaltung gespeichert wird.

4. Verfahren nach einem der vorstehenden Ansprüche, **dadurch gekennzeichnet, dass** bislang erfasste höchste Spannungswert von der Komparator-Schaltung mit einem Zeitstempel versehen und gespeichert wird.

5. Vorrichtung zur elektronischen Überwachung des Bordnetzes oder von Teilen des Bordnetzes eines Kraftfahrzeugs auf Spannungsspitzen oder Spannungseinbrüche, **dadurch gekennzeichnet, dass** die Vorrichtung ein Verfahren nach einem der vorstehenden Ansprüche ausführt.

6. Bordnetz mit einer elektronischen Überwachung des Bordnetzes oder von Teilen des Bordnetzes eines Kraftfahrzeugs auf Spannungsspitzen oder Spannungseinbrüche, **gekennzeichnet durch** eine Vorrichtung nach Anspruch 5.

## Claims

1. A method for the electronic monitoring of the on-board power supply system or parts of the on-board power supply system of a motor vehicle with respect to voltage peaks or voltage drops, wherein
- the value of the electric voltage is continuously recorded and a comparator circuit continuously compares a first earlier voltage value with a second subsequently determined voltage value, and
- the comparator circuit retains the previously recorded highest voltage value for a predetermined time period, **characterised in that**
- the electric voltage of the primary and/or secondary side of the ignition voltage circuit of the motor vehicle is continuously monitored, optionally after a reduction of the measuring voltage by a voltage divider.

2. A method according to claim 1, **characterised in that** the previously recorded highest voltage value, when a fault occurs in the on-board power supply system or in a control apparatus located in the on-board power supply system, is stored in a fault memory together with a description of the fault.

3. A method according to either of the preceding claims, **characterised in that** the previously recorded highest voltage value is compared by the comparator circuit with a predetermined threshold value, and the previously recorded highest voltage value is stored by the comparator circuit when the predetermined threshold value is exceeded.

4. A method according to any one of the preceding claims, **characterised in that** the previously recorded highest voltage value is provided with a time stamp by the comparator circuit and stored.

5. A device for the electronic monitoring of the on-board power supply system or parts of the on-board power supply system of a motor vehicle with respect to voltage peaks or voltage drops, **characterised in that** the device carries out a method according to any one of the preceding claims.

6. An on-board power supply system with an electronic monitoring system of the on-board power supply system or parts of the on-board power supply system of a motor vehicle with respect to voltage peaks or voltage drops, **characterised by** a device according to claim 5.

## Revendications

1. Procédé de surveillance électronique du réseau embarqué ou de parties du réseau embarqué d'un véhicule pour détecter des pics de tension ou des chutes de tension selon lequel :
- la valeur de la tension électrique est détectée en continu et un circuit comparateur compare en continu une première valeur de tension antérieure avec une seconde valeur de tension déterminée ultérieurement, et
- le circuit comparateur garde à disposition la valeur de tension la plus élevée jusqu'alors détectée pendant une période prédéterminée,
**caractérisé en ce que**
la tension électrique du côté primaire et/ou du côté secondaire du circuit de tension d'allumage du véhicule est surveillée en continu, le cas échéant après une réduction de la tension de mesure par un diviseur de tension.

2. Procédé conforme à la revendication 1,
**caractérisé en ce que**
la valeur de la tension la plus élevée jusqu'alors détectée est enregistrée dans une mémoire de défaut en cas d'arrivée d'un défaut dans le réseau embarqué ou dans un appareil de commande situé dans le réseau embarqué conjointement à une description du défaut.

3. Procédé conforme à l'une des revendications précédentes,
**caractérisé en ce que**
la valeur de tension la plus élevée jusqu'alors détectée est comparée par le circuit comparateur avec une valeur de seuil prédéfinie, et la valeur de tension la plus élevée jusqu'alors détectée est enregistrée par le circuit comparateur en cas de dépassement de la valeur de seuil prédéfinie.

4. Procédé conforme à l'une des revendications précédentes,
**caractérisé en ce que**
la valeur de tension la plus élevée jusqu'alors détectée est équipée d'un repère chronologique et enregistrée par le circuit comparateur.

5. Dispositif de surveillance électronique du réseau embarqué ou de parties du réseau embarqué d'un véhicule pour détecter des pics de tension ou des chutes de tension,
**caractérisé en ce qu'**
il met en oeuvre un procédé conforme à l'une des revendications précédentes.

6. Réseau embarqué équipé d'une surveillance électronique de ce réseau embarqué ou de parties de ce réseau embarqué dans un véhicule pour détecter des pics de tension ou des chutes de tension,
**caractérisé par**
un dispositif conforme à la revendication 5.
